(19) Europäisches Patentamt
European Patent Office
Office européen des brevets

(11) **EP 4 550 978 A1**

(12) **EUROPEAN PATENT APPLICATION**

(43) Date of publication:
**07.05.2025 Bulletin 2025/19**

(21) Application number: **24209922.4**

(22) Date of filing: **30.10.2024**

(51) International Patent Classification (IPC):
**H10D 30/66** (2025.01)   **H10D 12/00** (2025.01)
**H10D 62/00** (2025.01)   **H10D 62/10** (2025.01)

(52) Cooperative Patent Classification (CPC):
**H10D 62/058; H10D 12/441; H10D 30/0291;**
**H10D 30/66; H10D 62/052; H10D 62/111;**
**H10D 62/159**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **30.10.2023 CN 202311433891**

(71) Applicant: **Nexperia B.V.**
**6534 AB Nijmegen (NL)**

(72) Inventors:
• **Yin, Jianglong**
  **Shanghai (CN)**
• **Yang, Mengqi**
  **Shanghai (CN)**
• **Chen, Fan**
  **Shanghai (CN)**
• **Chen, Yanming**
  **Shanghai (CN)**

(74) Representative: **Pjanovic, Ilija**
**Nexperia B.V.**
**Legal & IP**
**Jonkerbosplein 52**
**6534 AB Nijmegen (NL)**

(54) **POWER SEMICONDUCTOR DEVICE AND ASSOCIATED METHODS**

(57)   A semiconductor power device comprising an active region, the active region comprising a drift region of a first conductivity type, a body region of a second conductivity type, wherein the second conductivity type is opposite to the first conductivity type, a super junction region arranged at least partially between the drift region and the body region, the super junction region comprising a first pillar of the first conductivity type, at least a portion of a second pillar of the second conductivity type, the first pillar being arranged adjacent to the portion of the second pillar, wherein at least one of: a doping concentration of the first pillar is constant in a direction along the first pillar from the drift region to the body region and a doping concentration of the portion of the second pillar decreases in a direction along the portion of the second pillar from the drift region to the body region, or the doping concentration of the first pillar increases in the direction along the first pillar from the drift region to the body region and the doping concentration of the portion of the second pillar is constant in the direction along the portion of the second pillar from the drift region to the body region.

FIG. 1

EP 4 550 978 A1

## Description

## Technical Field

The present disclosure relates to a power semiconductor device and a method of manufacturing a power semiconductor device. Particularly but not exclusively, the present disclosure relates to a super junction (SJ) metal-oxide semiconductor field-effect transistor (MOSFET).

## Background

Power semiconductor devices such as metal-oxide semiconductor field-effect transistors (MOSFETs) or insulated-gate bipolar transistors (IGBTs) require a high breakdown voltage. It is possible to achieve a high value of breakdown voltage in the active regions of super junction MOSFETS, for example by using a number of thin semiconductor layers in the super junction area to create charge balance. However, it can be difficult to improve the Figure of Merit (FOM), which corresponds to a ratio of the breakdown voltage over the specific resistance of a super junction MOSFET, when a cell pitch is decreased. For example, when the cell pitch is decreased, a doping concentration in the super junction region of the MOSFET may be increased to decrease the specific resistance. However, this can also lead to a decrease of the breakdown voltage, which may be due to an increased electric field at a top portion of the super junction region compared to an electric field at a bottom portion of the super junction region.

US 9,595,596 B2 relates to a power device, US 9,024,381 B2 relates to a semiconductor device, US6630698B1 relates to a high-voltage semiconductor component and US 8,283,720 B2 relates to power semiconductor device.

## Summary

Aspects and preferred features are set out in the accompanying claims.

According to a first aspect of the present disclosure, there is provided a semiconductor power device comprising an active region, the active region comprising:

a drift region of a first conductivity type;
a body region of a second conductivity type, wherein the second conductivity type is opposite to the first conductivity type;
a super junction region arranged at least partially between the drift region and the body region, the super junction region comprising:

a first pillar of the first conductivity type,
at least a portion of a second pillar of the second conductivity type, the first pillar being arranged adjacent to the portion of the second pillar, wherein at least one of:

a doping concentration of the first pillar is constant in a direction along the first pillar from the drift region to the body region and a doping concentration of the portion of the second pillar decreases in a direction along the portion of the second pillar from the drift region to the body region; or
the doping concentration of the first pillar increases in the direction along the first pillar from the drift region to the body region and the doping concentration of the portion of the second pillar is constant in the direction along the portion of the second pillar from the drift region to the body region.

By configuring a doping concentration of the first pillar to be constant in a direction along the first pillar from the drift region to the body region and a doping concentration of the portion of the second pillar to decrease in a direction along the portion of the second pillar from the drift region to the body region, or the doping concentration of the first pillar to increase in the direction along the first pillar from the drift region to the body region and the doping concentration of the portion of the second pillar to be constant in the direction along the portion of the second pillar from the drift region to the body region, a breakdown voltage of the device may be increased. This in turn may lead to an increase in a ratio of the breakdown voltage over a specific resistance of the device. This ratio may also be referred to the Figure of Merit (FOM).

Additionally, an electric field at a top or a surface of the active region may be decreased. This may lead to a more even distribution of the electric field in the active region of the device. The effect of decreasing of the electric field at the top or surface of the active region may also be referred to as Reduced Surface Field (RESURF).

Additionally, an impact ionisation location of the device may be located at a bottom of the super junction region, e.g. proximal to the drift region. This may result in an improved non-latch-up performance of the device. The improved latch-up performance may in turn result in a more even distribution of heat generated in the device.

The doping concentration of the portion of the second pillar may decrease linearly in the direction along the portion of the second pillar from the drift region to the body region. Alternatively, the doping concentration of the first pillar may increase linearly in the direction along the first pillar from the drift region to the body region.

The doping concentration of the portion of the second pillar may decrease stepwise in the direction along the portion of the second pillar from the drift region to the body region. Alternatively, the doping concentration of the first pillar may increase stepwise in the direction along the first pillar from the drift region to the body region.

The doping concentration of the portion of the second pillar may decrease in two or more steps. Alternatively, the doping concentration of the first pillar may increase in two or more steps.

The doping concentration of the first pillar at or near the body region may be larger, smaller or the same as the doping concentration of the portion of the second pillar at or near the body region.

The super junction region may comprises a plurality of first pillars and a plurality of second pillars. The plurality of first pillars and the plurality of second pillars may be alternately arranged with each other. The portion of the second pillar may be part of or comprised in at least one second pillar of the plurality of second pillars. Each of the plurality of first pillars may arranged adjacent at least one of the plurality of second pillars. Each of the plurality of first pillars may form a p-n-junction with the at least one of the plurality of second pillars.

The semiconductor device may comprise a metal-oxide-semiconductor field-effect transistor (MOSFET) or an insulated-gate bipolar transistor (IGBT).

The first pillar or each of the plurality of first pillars may comprise or define a further drift region. The portion of the second pillar, the second pillar or each of the plurality of second pillars may comprise or define a partition region.

According to a second aspect of the present disclosure there is provided a method of manufacturing an active region of a semiconductor power device, the method comprising:

> forming a drift region of a first conductivity type on a substrate;
> forming a super junction region on the drift region, the super junction region comprising:
>
> > a first pillar of the first conductivity type,
> > at least a portion of a second pillar of the second conductivity type, the first pillar being arranged adjacent to the portion of the second pillar, wherein at least one of:
> >
> > > a doping concentration of the first pillar is constant in a direction along the first pillar from the drift region to the body region and a doping concentration of the portion of the second pillar decreases in a direction along the portion of the second pillar from the drift region to the body region; or
> > > the doping concentration of the first pillar increases in the direction along the first pillar from the drift region to the body region and the doping concentration of the portion of the second pillar is constant in the direction along the portion of the second pillar from the drift region to the body region;

forming a body region of a second conductivity type on at least a part of the super junction region.

Forming the super junction region may comprise:
performing each of steps (i) to (v) one or more times:

> (i) depositing a semiconductor layer on or over the drift region;
> (ii) forming a first mask on the semiconductor layer, the first mask exposing an upper surface of a first region of the semiconductor layer;
> (iii) selectively doping the first region of the semiconductor layer to form a first region of a first conductivity type;
> (iv) forming a second mask on the semiconductor layer, the second mask exposing an upper surface of a second region of the semiconductor layer, the second region of the semiconductor layer being laterally spaced from the first region of the semiconductor layer; and
> (v) selectively doping the second region of the semiconductor layer to form a second region of a second conductivity type.

In a first iteration, the semiconductor layer may be deposited on the drift region. In one or more subsequent iterations, a subsequent semiconductor layer may be deposited on a previously deposited semiconductor layer.

When at least one subsequent iteration has been performed, a doping concentration of each first region of the first conductivity type may be the same. When at least one subsequent iteration has been performed, a doping concentration of a second region of the second conductivity type formed in the at least one subsequent iteration may be decreased relative to a doping concentration of a second region of the second conductivity type formed in a previous iteration.

When at least one subsequent iteration has been performed, a doping concentration of each second region of the second conductivity type may be the same. When at least one subsequent iteration has been performed, a doping concentration of a first region of the first conductivity type formed in the at least one subsequent iteration may be increased relative to a doping concentration of a first region of the first conductivity type formed in a previous iteration.

The method may comprise using a diffusion or redistribution process to form the first pillar and at least the portion of the second pillar.

Forming the super junction region may comprise forming a trench in a semiconductor region of a first conductivity type. The method may comprise forming the body region prior to forming the trench. The trench may be formed such that the trench extends through the body region into semiconductor region. The trench may extend into the semiconductor region in a vertical direction. The trench may be formed such that the trench is in contact with the body region. The trench may be formed such that the trench is in contact with the drift region.

A portion of the semiconductor region that is located adjacent to the trench may form the first pillar. Forming the super junction region may comprise filling the trench with a semiconductor material of a second conductivity type to form at least the portion of the second pillar.

According to a third aspect of the present disclosure there is provided a method of manufacturing a semiconductor power device comprising manufacturing an active region of the semiconductor power device according to the second aspect.

The device and method of manufacture of the present disclosure has one or more of the following advantages over state-of-the-art devices:

- The device may have an increased breakdown voltage and increased Figure of Merit;
- A distribution of an electric field in the active region may be improved;
- The Reduced Surface Field (RESURF) effect may be improved;
- A non-latch-up performance of the device may be improved;
- A distribution of heat generated in the active region of the device may be more even;
- The manufacturing steps may be compatible with existing MOSFET and/or IGBT manufacturing processes and/or may be performed using materials and processing equipment commonly available in MOSFET and/or IGBT fabs.

**Brief Description of the Drawings**

Some embodiments of the disclosure will now be described, by way of example only and with reference to the accompanying drawings, in which:

Figure 1 shows schematically a cross-section of an active region of a semiconductor device;

Figure 2 shows schematically a cross-section of a half of a unit cell of the device of Figure 1;

Figures 3(a) to 3(f) show schematically different exemplary distributions of dopant dosages that may be used to form a first pillar and a second pillar of the device of Figures 1 and 2;

Figure 4 shows an active charge carrier concentration in an exemplary semiconductor power device that has been simulated using the distribution of the n-type dopant and p-type dopant implantation dosages of Figure 3(a);

Figure 5 shows a graph of drain source current curves over a breakdown voltage that have been simulated for each of the n-type dopant and p-type dopant implantation dosage distributions of Figure 3(a) to 3(f);

Figure 6 shows a graph of electric field curves over a distance between a drain contact and a source contact of the device of Figures 1 and 2 that have been simulated for each of the n-type dopant and p-type dopant implantation dosage distributions of Figure 3(a) to 3(f);

Figure 7 shows a comparison between the breakdown voltage, specific resistance and Figure of Merit that has been simulated for each of the n-type dopant and p-type dopant implantation dosage distributions of Figures 3(a) to 3(f);

Figures 8(a) to 8(f) show simulations of impact ionisation locations that have been simulated for each of the n-type dopant and p-type dopant implantation dosage distributions of Figures 3(a) to 3(f);

Figures 9(a) to 9(f) show exemplary n- type dopant and p-type dopant concentrations of the first and second pillars, respectively, of the device of Figures 1 and 2 according to embodiments of the present disclosure;

Figures 10(a) to 10(f) show exemplary n-type dopant and p-type dopant concentrations of the first and second pillars, respectively, of the device of Figures 1 and 2 according to embodiments of the present disclosure;

Figures 11(a) to 11(f) shows steps of a method of manufacturing an active region of a semiconductor power device according to an embodiment of the disclosure;

Figures 12(a) to 12(k) shows steps of another method of manufacturing an active region of a semiconductor power device according to an embodiment of the disclosure; and

Figure 13 shows schematically a cross-section of a super junction region that has been formed using one or more steps of the method of Figures 12(a) to 12(k).

**Detailed Description of the Preferred Embodiments**

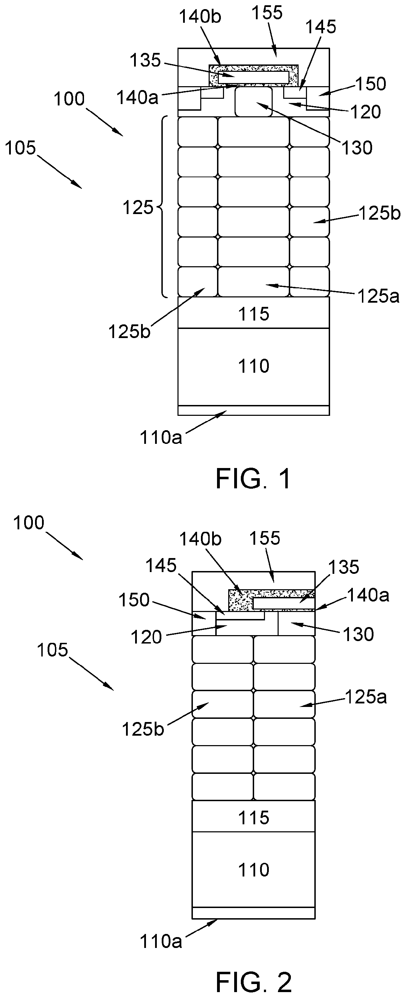

Figures 1 and 2 show schematically a cross-section of an active region 105 of a semiconductor device 100. The active region 105 shown in Figure 1 may be considered as a unit cell, which may be repeated thousands of times in the device 100. The active region 105 shown in Figure 2 may be considered as a half of the unit cell shown in Figure 1. In the examples described herein, the device 100 is a silicon based super junction MOSFET. However, it will be appreciated that the device may comprise one or more alternative semiconductor materials. For example, the device may alternatively be silicon carbide (SiC) or Gallium Nitride (GaN) based.

The active region 105 comprises a substrate 110 of a first conductivity type. The substrate 110 may comprise an n-type doped semiconductor material, such as $n^+$ silicon. An n-type dopant concentration of the substrate 110 may be larger than about $5 \times 10^{18}$ cm$^{-3}$. The substrate 110 is conductive and acts as a drain region. A thickness of the substrate may be between about 40 $\mu$m and about 100 $\mu$m.

The active region 105 comprises a drift region 115 arranged on the substrate 110. The drift region 115 comprises an n-type doped semiconductor material, such as n-type doped silicon. An n-type dopant concentration of the drift region 115 may be between about $5 \times 10^{14}$ cm$^{-3}$ and $5 \times 10^{17}$ cm$^{-3}$, such as about $7 \times 10^{15}$ cm$^{-3}$. The drift region 115 may also be referred to as an n-drift region, n-type buffer region or n-type voltage sustaining region. The drift region 115 is formed on or over the semiconductor substrate 110. In this embodiment, the drift region 115 comprises one or more epitaxial layers and has a thickness of about 15 $\mu$m. However, it will be appreciated that in other embodiments, the drift region may have a thickness that is more or less than 15 $\mu$m.

A drain contact 110a may be arranged on an underside of the substrate 110, e.g. a side of the substrate 110 that is opposite to the drift region 110. The drain contact 110a may comprise a conductive material, such as a metal material. The metal material may comprise a metal alloy, such as titanium nickel silver or another metal alloy.

The active area 105 includes a body region 120 of a second conductivity type. The second conductivity type is opposite to the first conductivity type. In the embodiment shown in Figures 1 and 2, the body region 120 comprises a p-type semiconductor material.

The active area 105 includes a super junction region 125. The super junction region 125 is arranged between the drift region 115 and the body region 120. The super junction region 125 comprises a plurality of first pillars 125a of the first conductivity type and a plurality of second pillars 125b of the second conductivity type. In this embodiment, each first pillar 125a is an n-type pillar and each second pillar 125b is a p-type pillar. The first pillars 125a may define further drift regions. The second pillars 125b may define partition regions. The first and second pillars 125a, 125b are alternately arranged and in contact with each other. For example, each first pillar 125a is arranged between two adjacent second pillars 125b. For example, in the unit cell shown in Figure 1, the super junction region 125 comprises a first pillar 125a and two portions of two respective second pillars 125b. The first pillar 125a is arranged between the two portions the second pillars 125b. In the half of the unit cell shown Figure 2, the super junction region comprises a portion of the first pillar 125a and a portion of the second pillar 125b. The portions of the first and second pillars 125a, 125b are arranged adjacent to each other. This arrangement results in the formation of parallel p-n-junctions extending in a vertical direction between the drift region 115 and the body region 120. The super junction region 125 may also be referred to as a p-n-junction region.

In this embodiment, a width of each of the first and second pillars 125a, 125b may be about 3.5 $\mu$m. A height of each of the first and second pillars 125a, 125b may be between about 3 $\mu$m and 6 $\mu$m. However, it will be appreciated that the first and second pillars are not limited to having the exemplary height and/or width disclosed herein.

The active region 105 comprises an n-type doped JFET region 130. The JFET region is arranged above the first pillar 125a. The JFET region 130 is arranged to extend from the first pillar to an upper surface of the body region 120. The body region 120 is arranged on either side of the JFET region 130.

The active region 105 comprises a gate conductive region 135. The gate conductive region 135 is located above the JFET region 130 and the body region 120. The gate conductive region 135 is used to control a conduction channel in the active region 105.

The active region 105 comprises a first insulation region 140a. The first insulation region 140a is arranged between the JFET region 130 and the gate conductive region 135. The first insulation region 140a may extend along the sides of the gate conductive region 135. The first insulation region may be referred to as a gate oxide region 140a.

The active region 105 comprises a second insulation region 140b. The second insulation region 140b is arranged on or over the gate conductive region 135 and the gate oxide region 140a. The second insulation region may also be referred to as an interlayer dielectric layer 140b.

The device 100 includes source contact regions, which in this example are $n^+$ source contact regions 145. The $n^+$ source contact regions 145 are arranged on either side of the JFET region 130 and below the gate oxide region 140a. During operation, a conduction channel is formed between the $n^+$ source contact regions 145 and the drift region 115 by application of a positive voltage to the gate conductive region 135.

The body region 120 comprises a contact region, which in this example comprises $p^+$ contact regions 150. The $p^+$ contact regions 150 are formed on either side of the JFET region 130 and adjacent a respective $n^+$ source contact 145 region.

The device 100 comprises a source contact 155. The source contact 155 may comprise a conductive material, such as a metal material. The metal material may comprise aluminium, tungsten, titanium or a combination thereof. The source contact 155 is located on an upper surface of the device. For example, the source contact 155 may be arranged on or over the interlayer dielectric layer 140b. The source contact 155 may also be arranged to contact the n+ source contact 145 regions and the p+ contact regions 150.

In the embodiments shown in Figure 1, a lateral extension or a width of the unit cell of the device 100 is about 7 $\mu$m. However, it will be appreciated that in other embodiments, the lateral extension or cell pitch may be more or less than 7 $\mu$m. The lateral extension or the width of the unit cell of the device may also be referred to as cell pitch.

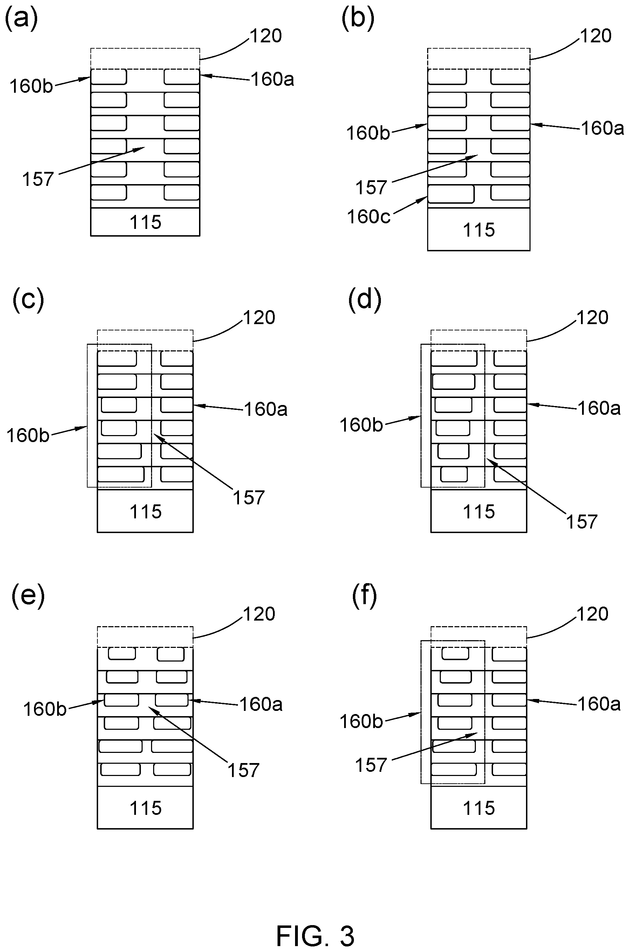

Figures 3(a) to 3(f) show schematically different exemplary distributions of dopant dosages that may be used to form the first and second pillars 125a, 125b. As will be described below in more detail, the first and second pillars 125a, 125b may be formed by implantation of an n-type dopant and p-type dopant, respectively, in a plurality of semiconductor layers, which are indicated in Figures 3(a) to 3(f) by reference numeral 157. The semiconductor layers 157 may also be referred to as epitaxial layers. Each of the semiconductor layers may have a thickness of about 6 $\mu$m. However, it will be appreciated that in other embodiments, a thickness of each semiconductor layer may be more or less than 6 $\mu$m.

The n-type dopant dosage is indicated by reference numeral 160a and the p-type dopant dosage is indicated by reference numeral 160b. For sake of clarity only the drift region 115 and the body region 120 are indicated in Figures 3(a) to 3(f).

In the examples shown in Figures 3(a) to 3(f), the first and second pillars 125a, 125b are formed from six semiconductor layers 157. However, it will be appreciated that in other embodiments, the first and second pillars may be formed from more or less than six semiconductor layers.

In the example shown in Figure 3(a), each of the semiconductor layers 157 is implanted with the same dosage of the p-type dopant and n-type dopant. For example, the p-type dopant 160b and the n-type dopant 160a implantation dosages may be about 1.1 x $10^{13}$ cm$^{-2}$.

As such, a doping concentration of each of the first and second pillars 125a, 125b is constant in a direction along each of the first and second pillars 125a, 125b from the drift region 115 to the body region 120. The terms "a direction along the first/second pillar" may be understood as encompassing the terms "a direction parallel to a longitudinal axis of the first/second pillar." The direction along the first/second pillar may also be referred to as a vertical direction.

In the example shown In Figure 3(b), a p-type dopant dosage 160b of the semiconductor layer 157 adjacent the drift region 115 is higher relative to the p-type dopant of the remaining semiconductor layers 157. As such, a p-type dopant enrichment region 160c is formed in the second pillar 125b in proximity of the drift region 115. For example, the p-type dopant dosage of the enrichment region 160c is about 1.2 x $10^{13}$ cm$^{-2}$. The p-type dopant dosage of each of the remaining semiconductor layers 157 may be about 1.1 x $10^{13}$ cm$^{-2}$. The n-type dopant dosage 160a is the same for each semiconductor layer 157. For example, the n-type dopant dosage is about 1.1 x $10^{13}$ cm$^{-2}$ for each semiconductor layer 157. The doping concentration of the first pillar 125a is constant in the direction along the first pillar 125a from the drift region 115 to the body region 120. In the example shown in Figure 3(c), the p-type dopant dosage 160b is varied across the semiconductor layers 157 in the direction from the drift region 115 to the body region 120. In this example, the p-type dopant dosage gradually decreases and then gradually increases in the direction from the drift region 115 to the body region 120. For example, the p-type dosage decreases from about 1.16 x $10^{13}$ cm$^{-2}$ to about 1.11 x $10^{13}$ cm$^{-2}$ and then increases from about 1.11 x $10^{13}$ cm$^{-2}$ to about 1.16 x $10^{13}$ cm$^{-2}$. The n-type dopant dosage 160a is the same for each semiconductor layer 157. For example, the n-type dopant dosage 160a is about 1.1 x $10^{13}$ cm$^{-2}$ for each semiconductor layer 157.

In the example shown in Figure 3(d), the p-type dopant dosage 160b is varied across the semiconductor layers 157 in the direction from the drift region 115 to the body region 120. In this example, the p-type dopant dosage 160b gradually increases in the direction from the drift region 115 to the body region 120. For example, the p-type dosage increases from about 1.07 x $10^{13}$ cm$^{-2}$ to about 1.12 x $10^{13}$ cm$^{-2}$. The n-type dopant dosage 160a is the same for each semiconductor layer 157. For example, the n-type dopant dosage 160a is about 1.1 x $10^{13}$ cm$^{-2}$ for each semiconductor layer 157.

In the example shown in Figure 3(e), the n-type dopant and p-type dopant dosages 160a, 160b are varied across the semiconductor layers 157 in the direction from the drift region 115 to the body region 120. In this example, the n-type dopant and p-type dopant dosages 160a, 160b simultaneously increase and then decrease in the direction from the drift region 115 to the body region 120. For example, the n-type dopant and p-type dopant dosages 160a, 160b simultaneously increase from about 1.1 x $10^{13}$ cm$^{-2}$ to about 1.16 x $10^{13}$ cm$^{-2}$ and then decreases from about to 1.05 x $10^{13}$ cm$^{-2}$.

Figure 3(f) shows the n-type dopant and p-type dopant implanting dosages 160a, 160b according to an embodiment of the present disclosure. In Figure 3(f), the p-type dopant dosage 160b is varied across the semiconductor layers 157 in the direction from the drift region 115 to the body region 120. For example, the p-type dopant dosage 160b decreases in the direction from the drift region 115 to the body region 120. The p-type dopant dosage 160b may decrease from about 1.16 x $10^{13}$ cm$^{-2}$ to about 1.09 x $10^{13}$ cm$^{-2}$.

The n-type dopant dosage 160a is the same for each semiconductor layer 157. The n-type dopant dosage may be about 1.1 x $10^{13}$ cm$^{-2}$. It will be appreciated that in other embodiments, the n-type dopant dosage may be varied across the semiconductor layers and the p-type dopant dosage may be constant. In such other embodiments, the n-type dopant dosage may be increased, e.g. from about 1.05 x 10^13 cm^-2 to 1.11 x 10^13 cm^-2, in the direction from the drift region to the body region. In such other embodiments, the p-type dopant dosage may be the same for each semiconductor layer. For example, the p-type dopant dosage may be about 1.1 x 10^13 cm^-2.

An implantation energy used for implanting the p-type dopant in the above examples may be between about 100 KeV and 850 KeV. An implantation energy used for implanting the n-type dopant in the above examples may be between about 140 KeV and 950 KeV.

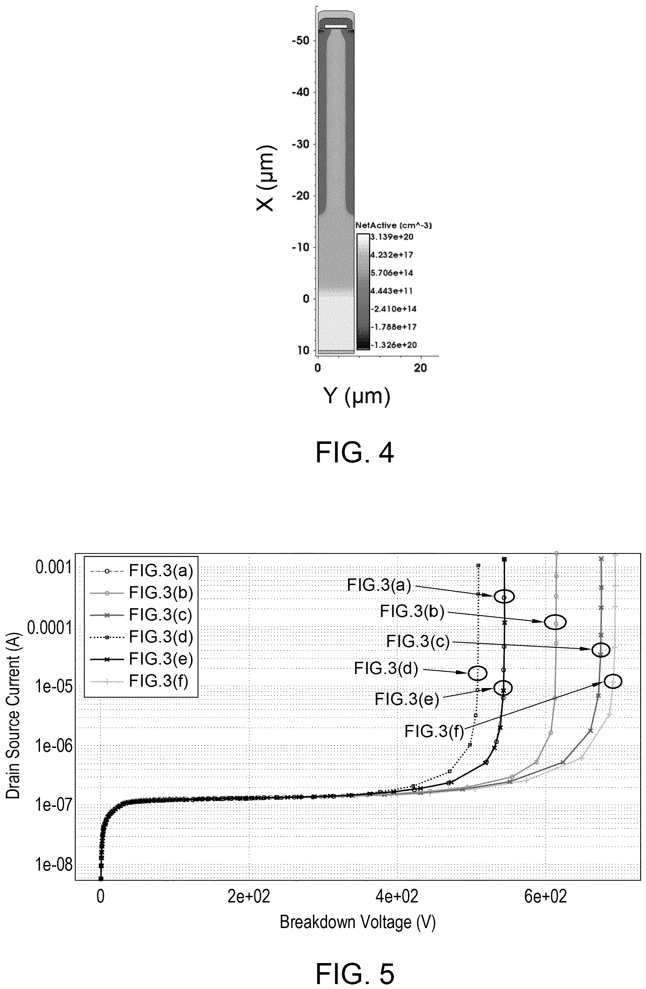

Figure 4 shows an active charge carrier concentration in an exemplary semiconductor power device that has been simulated using the distribution of the n-type dopant and p-type dopant implantation dosages described in relation to Figure 3(a). In other words, the n-type dopant and the p-type dopant concentrations of the first and second pillars, respectively, were assumed to be constant in the direction along the first and second pillars, respectively, from drift region to the body region, as described in relation to Figure 3(a).

Figure 5 shows a graph of simulated drain source current curves over a breakdown voltage. The curves shown in Figure 5 have been simulated for each of the n-type dopant and p-type dopant implantation dosage distributions described in relation to Figure 3(a) to 3(f), using the parameters of the device 100 described herein.

It can be seen from Figure 5 that the highest breakdown voltage has been simulated for the device 100 with n-type dopant and p-type dopant implantation dosages as described in the Figure 3(f). In other words, by configuring the device 100 with a first pillar 125a having a constant n-type dopant concentration in the direction along the first pillar 125a from the drift region 115 to the body region 120 and at least a portion of a second pillar 125b having a p-type dopant concentration that decreases in the direction along the second a pillar 125b from the drift region 115 to the body region 120, a breakdown voltage of the device 100 may be increased. This in turn leads to an increase in a ratio of the breakdown voltage over a specific resistance of the device 100. This ratio may also be referred to the Figure of Merit (FOM).

Additionally, by configuring the device 100 with a first pillar 125a having a constant n-type dopant concentration in the direction along the first pillar 125a from the drift region 115 to the body region 120 and at least a portion of a second pillar 125b having a p-type dopant concentration that decreases in the direction along the second pillar 125b from the drift region 115 to the body region 120, an electric field at the top of the active region 105 may be decreased, leading to a more even distribution of the electric field in the active region 105 of the device 100. The effect of decreasing of the electric field at the top of the active region 105 may also be referred to as Reduced Surface Field (RESURF).

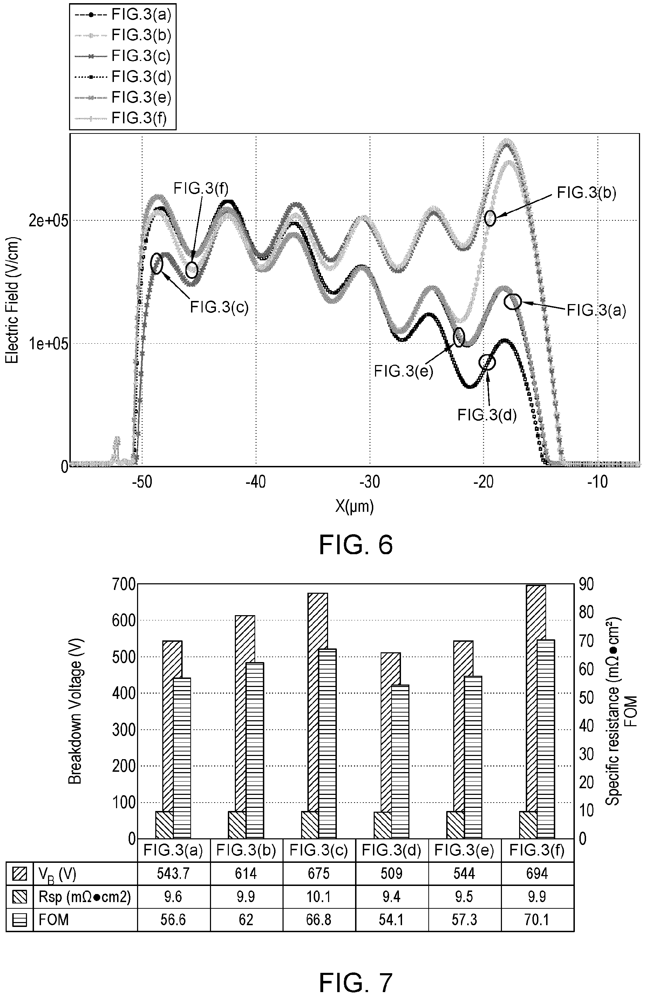

Figure 6 shows a graph of electric field curves over a distance X between the drain contact and the source contact of the device. The curves shown in Figure 6 have been simulated for each of the n-type dopant and p-type dopant implantation dosage distributions described in relation to Figure 3(a) to 3(f), using the parameters of the device 100 described herein. It can be seen from Figure 6 that the electric field is more evenly distributed between the source contact 155 and the drain contact 110a for the device 100 with n-type dopant and p-type dopant implantation dosages as described in Figure 3(f) compared to electric field curves simulated for the devices with the n-type dopant and p-type dopant implantation dosage distributions described in relation to Figure 3(a) to 3(e). In addition, it can be seen from Figure 6 that the electric field is decreased in proximity of the source contact 155 for the device 100 with n-type dopant and p-type dopant implantation dosages as described in the Figure 3(f) compared to electric field curves simulated for the devices with the n-type dopant and p-type dopant implantation dosage distributions described in relation to Figure 3(a), 3(b), 3(d) and 3(e). Although the simulated electric field for the devices with the n-type dopant and p-type dopant implantation dosage distributions described in relation to Figure 3(c) is decreased in proximity at the source contact, it is less even in the remainder of the active region compared to the electric field simulated for the device 100 with n-type dopant and p-type dopant implantation dosages as described in the Figure 3(f).

The electric field curves simulated for the devices with the n-type dopant and p-type dopant implantation dosage distributions as described in Figures 3(a) and 3(e) are very similar. It can be seen that the electric field simulated for these n-type dopant and p-type dopant implantation dosage distributions decreases towards the drain contact. The electric field curves simulated for the devices with the n-type dopant and p-type dopant implantation dosage distributions as described in Figures 3(b) and 3(d) are similar to those for the device with the n-type dopant and p-type dopant implantation dosage distributions as described in Figures 3(a) and 3(e). However, the electric field curve simulated for the device with the n-type dopant and p-type dopant implantation dosage distribution as described in relation to Figure 3(b) increases in proximity of the drain contact, whereas the electric field curve simulated for the device with the n-type dopant and p-type dopant implantation dosage distribution as described in relation to Figure 3(d) is decreased in proximity of the drain contact compared to the electric field curves of the other devices. The electric field curve simulated for the device with the n-type dopant and p-type dopant implantation dosage distribution as described in relation to Figure 3(c) is decreased in proximity of the source contact compared to the electric field curves of the other devices.

Figure 7 shows a comparison of the breakdown voltage, specific resistance and Figure of Merit that has been simulated for each of the n-type dopant and p-type dopant implantation dosage distributions as described in Figures 3(a) to 3(f), using the parameters of the device disclosed herein.

The specific resistance $R_{sp}$ is as follows:

$$R_{sp} = 2 * W_{pitch} * \frac{V_B}{\mu * \varepsilon_S * E_C^2},$$

where $W_{pitch}$ is the width of the unit cell, $V_B$ is the breakdown voltage, $\mu$ is the electron mobility, $\varepsilon_S$ is the permittivity of silicon and $E_C$ is the critical electric field. As described above the Figure of Merit corresponds to the ratio $V_B/R_{sp}$.

From Figure 7, it can be seen that the breakdown voltage increases from about 543.7 V for the device with the n-type dopant and p-type dopant implantation dosage distribution as described in Figure 3(a) to 694 V for the device with the n-type dopant and p-type dopant implantation dosage distribution as described in Figure 3(f). The specific resistance increases from 9.6 m$\Omega\cdot$cm$^2$ for the device with the n-type dopant and p-type dopant implantation dosage distribution as described in relation to Figure 3(a) to 9.9 m$\Omega\cdot$cm$^2$ for the device with the n-type dopant and p-type dopant implantation dosage distribution as described in relation to Figure 3(f). However, the Figure of Merit has increased from 56.6 for the device with the n-type dopant and p-type dopant implantation dosage distribution as described in relation to Figure 3(a) to 70.1 for the device with the n-type dopant and p-type dopant implantation dosage distribution as described in relation to Figure 3(f).

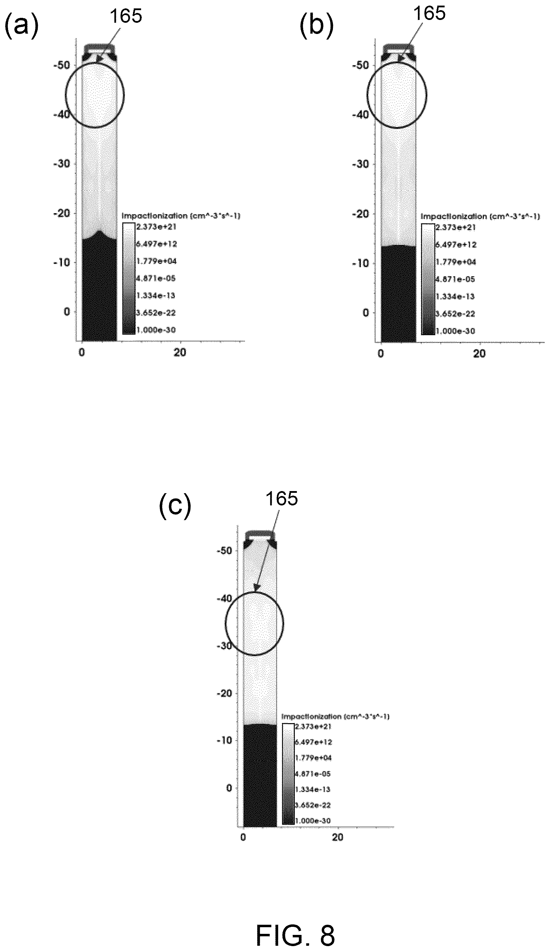

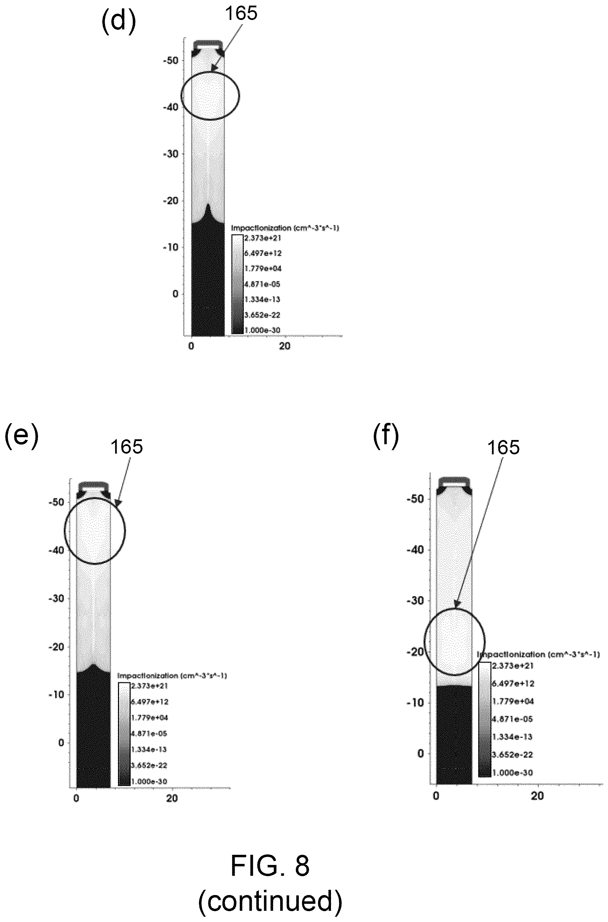

Figures 8(a) to 8(f) show simulations of impact ionisation locations 165. The impact ionisation locations 165 shown in Figures 8(a) to 8(f) have been simulated for each of the n-type dopant and p-type dopant implantation dosage distributions as described in relation Figures 3(a) to 3(f), using the parameters of the device 100 described herein. The impact ionisation location 165 may be considered as a location at which breakdown occurs. It can be seen from Figures 8(a), 8(b), 8(d) and 8(e) that for the corresponding devices with the n-type dopant and p-type dopant implantation dosage distributions as described in relation to Figures 3(a), 3(b), 3(d) and 3(e), respectively, the simulated impact ionisation location 165 is at or near the body region 120. For the device with the n-type dopant and p-type dopant implantation dosage distribution as described in relation to Figure 3(c), the impact ionisation location 165 is near a centre of the super junction region 125. For the device with the n-type dopant and p-type dopant implantation dosage distribution as described in Figure 3(f), the impact ionisation location 165 is at the bottom of the super junction region 125. For example, for the device with the n-type dopant and p-type dopant implantation dosage distribution as described in Figure 3(f), the impact ionisation location 165 is proximal to the drift region 115. This may result in an improved non-latch-up performance of the device 100 with the n-type dopant and p-type dopant implantation dosage distribution as described in Figure 3(f). Latch-up may be understood as a creation of a low-impedance path between regions of the device 100 that triggers turn-on of a parasitic n-p-n bipolar transistor structure between the source contact regions 145, the body region 120 and the first pillar 125 or the drain region 115. The improved latch-up performance may in turn result in a more even distribution of heat generated in the device 100 compared to the devices with the n-type dopant and p-type dopant implantation dosage distributions as described in relation to Figures 3(a) to 3(e).

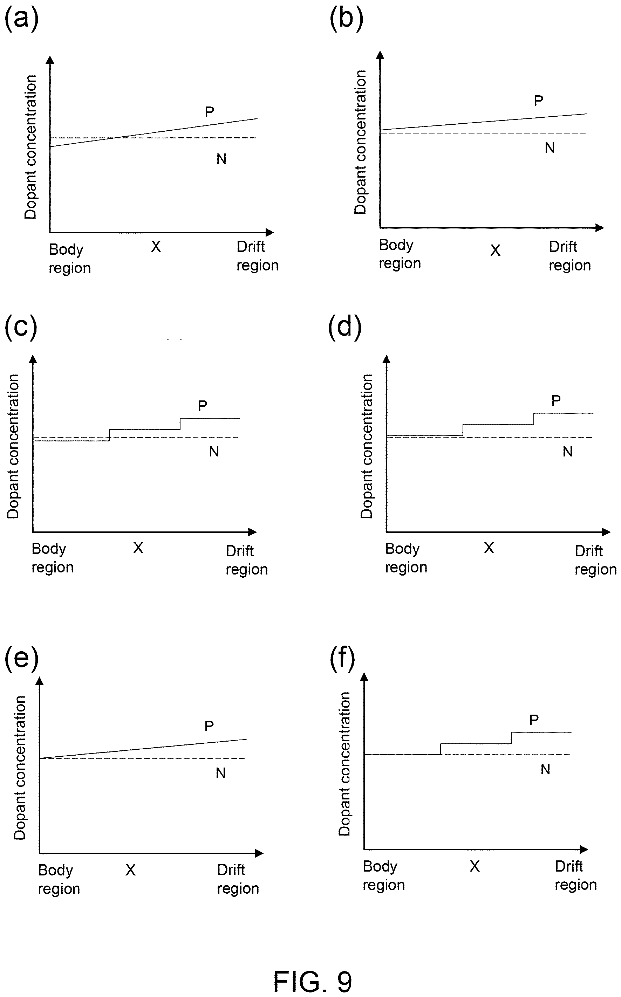

Figures 9(a) to 9(f) show exemplary n-type dopant and p-type dopant concentrations of the first and second pillars 125a, 125b, respectively, according to embodiments of the present disclosure. In the examples shown in Figures 9(a) to 9(f), the concentration of the n-type dopant of the first pillar 125a is constant in the direction X along the first pillar 125a from the drift region 115 to the body region 120. The concentration of the p-type dopant of the second pillar decreases in the direction X along the second pillar 125b from the drift region 115 to the body region 120.

In some embodiments, the p-type dopant concentration of the second pillar 125b at or near the body region 120 is less than the n-type dopant concentration of the first pillar 125a, as shown in Figures 9 (a) and 9(c).

In some embodiments, the p-type dopant concentration of the second pillar 125b at or near the body region 120 is larger than the n-type dopant concentration of the first pillar 125a, as shown in Figures 9 (b) and 9(d).

In some embodiments, the p-type dopant concentration of the second pillar 125b at or near the body region 120 may be the same as the n-type dopant concentration of the first pillar 125a, as shown in Figure 9(e) and 9(f).

In some embodiments, the p-type dopant concentration of the second pillar 125b decreases linearly in the direction X along the second pillar 125b from the drift region 115 to the body region 120, as shown in Figures 9(a), 9(b) and (e).

In some embodiments, the p-type dopant concentration of the second pillar 125b decreases stepwise in the direction X along the second pillar 125b from the drift region 115 to the body region 120, as shown in Figures 9(c), 9(d) and 9(f). In the examples shown in Figures 9(c), 9(d) and 9(f), the p-type dopant concentration of the second pillar 125b decreases in three steps in the direction X along the second pillar 125b from the drift region 115 to the body region 120. However, it will be appreciated that in other embodiments, p-type dopant concentration may decrease in more than three steps or at least two steps in the direction along the second pillar from the drift region to the body region.

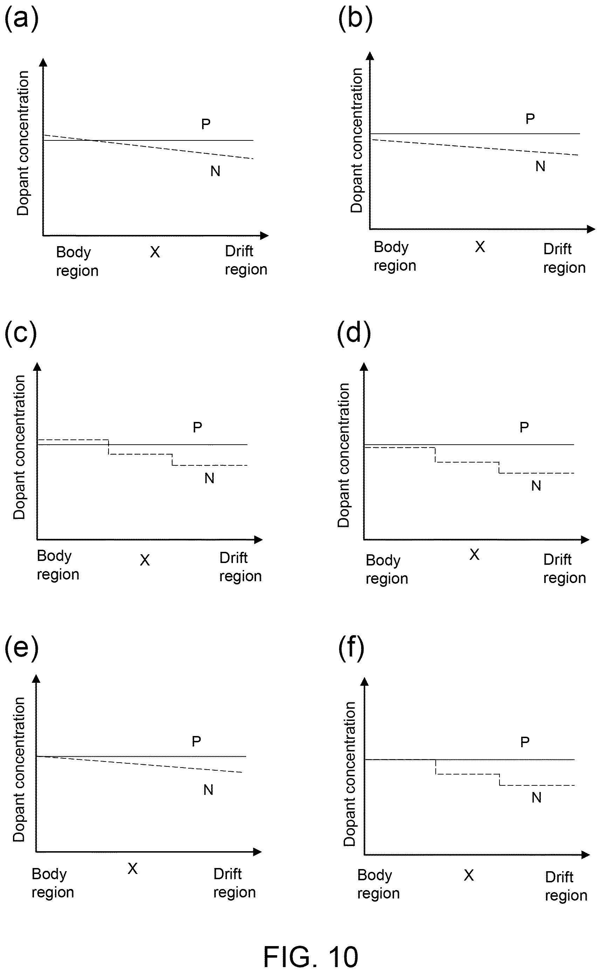

Figures 10(a) to 10(f) show exemplary n-type dopant and p-type dopant concentrations of the first and second pillars 125a, 125b, respectively, according to embodiments of the present disclosure. In the examples shown in Figures 10(a) to 10(f), the concentration of the p-type dopant of the second pillar 125b is constant in the direction X along the second pillar 125b from the drift region 115 to the body region 120. The concentration of the n-type dopant of the first pillar 125a increases in the direction X along the first pillar 125a from the drift region 115 to the body region 120.

In some embodiments, the p-type dopant concentration of the second pillar 125b at or near the body region 120 is less than the n-type dopant concentration of the first pillar 125a, as shown in Figures 10 (a) and 10(c).

In some embodiments, the p-type dopant concentration of the second pillar 125b at or near the body region 120 is larger than the n-type dopant concentration of the first pillar 125a, as shown in Figures 10(b) and 10(d).

In some embodiments, the p-type dopant concentration of the second pillar 125b at or near the body region 120 may be the same as the n-type dopant concentration of the first pillar 125a, as shown in Figure 10(e) and 10(f).

In some embodiments, the n-type dopant concentration of the first pillar 125a increases linearly in the direction X along the first pillar 125a from the drift region 115 to the body region 120, as shown in Figures 10(a), 10(b) and 10(e).

In some embodiments, the n-type dopant concentration of the first pillar 125a increases stepwise in the direction X along the first pillar 125a from the drift region 115 to the body region 120, as shown in Figures 10(c), 10(d) and 10(f). In the examples shown in Figures 10(c), 10(d) and 10(f), the n-type dopant concentration of the first pillar 125a increases in three steps in the direction X along the first pillar 125a from the drift region 115 to the body region 120. However, it will be appreciated that in other embodiments, n-type dopant concentration may increase in more than three steps or at least two steps in the direction from the drift region to the body region.

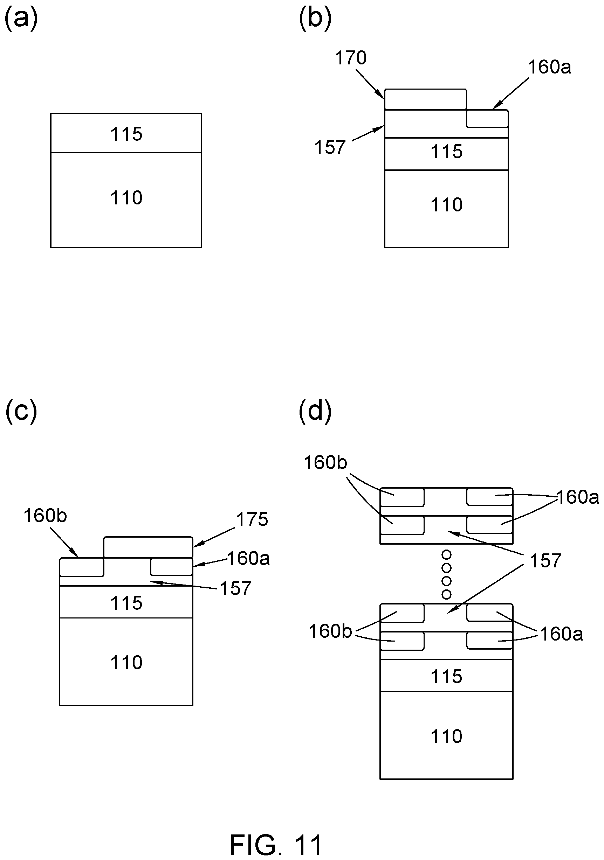

Figures 11(a) to 11(f) shows steps of a method of manufacturing an active region of a semiconductor power device according to an embodiment of the disclosure, such as the active region 105 of the device 100 described above. Many of the features are the same as those shown in Figures 1 and 2 and therefore carry the same reference numerals. It will be appreciated that the steps shown in Figures 11(a) to 11(f) may illustrate a subset of all the steps for manufacturing a device, and that the method may further include additional steps preceding or following the steps of Figures 11(a) to 11(f). Whilst Figures 11(a) to 11(f) show steps in manufacturing an active area having one first pillar 125a and two second pillars 125b, it will be understood that the method may be used to manufacture an active region comprising more than one first pillar and more than two second pillars.

In step (a), the method comprises forming the drift region 115 on the substrate 110. The drift region 115 may be formed on the substrate 110 using a deposition process.

In steps (b) to (e), the method comprises forming the super junction region 125 on the drift region 115.

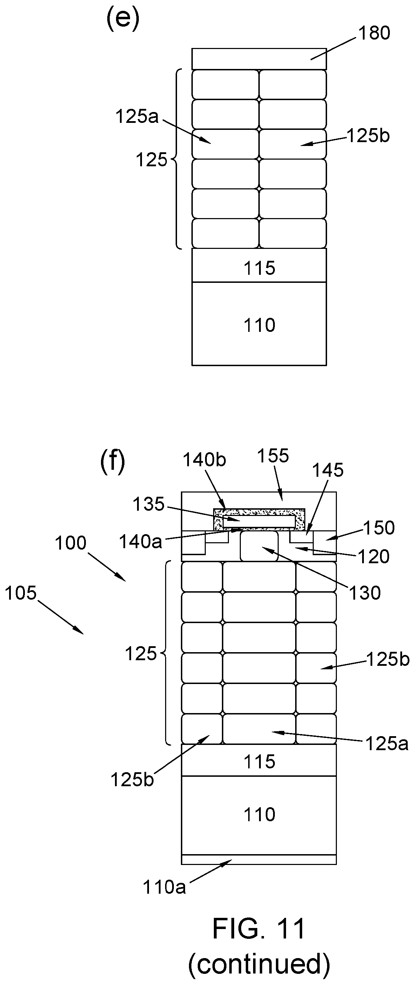

Steps (b) to (c) may each be performed in turn a plurality of times. In the example shown in Figure 11, the steps (b) and (c) are performed six times. However, it will be appreciated that these steps may be performed more or less than six times.

In step (b), the method comprises depositing a semiconductor layer 157 on or over the drift region 115. The semiconductor layer 157 may be deposited using a deposition process. The method comprises forming a first mask 170 on the semiconductor layer 157. The step of forming the first mask 170 on the semiconductor layer 157 may comprise depositing a layer of mask material, such as a layer of resist or photoresist material, on the semiconductor layer 157. The step of forming the first mask 170 on the semiconductor layer 157 may comprise patterning the layer of mask material. This may comprise exposing a part of the layer of mask material. The step of forming the first mask 170 on the semiconductor layer 157 may comprise developing the layer of mask material. A material removal process, such as etch process, may be used to remove the exposed part of the layer of mask material, thereby forming the first mask 170.

The first mask 170 exposes an upper surface of a first region of the semiconductor layer 157. The exposed upper surface of the first region of the semiconductor layer 157 may have a width of about 2.6 $\mu$m. The exposed upper surface of the first region of the semiconductor layer 157 may also be referred to as an opening of the first mask 170. It will be appreciated that in other embodiments, the width of the exposed upper surface of the first region of the semiconductor layer may be more or less than 2.6 $\mu$m.

The method comprises is selectively doping the first region of the semiconductor layer 157 by implanting an n-type dopant. The n-type dopant may comprise phosphor, arsenic or another n-type dopant. The n-type dopant dosage is indicated in Figure 11 by reference numeral 160a.

In step (c), the method comprises forming a second mask 175 on the semiconductor layer 157. The second mask 175 may be formed in the same manner as the first mask 170. The second mask 175 exposes an upper surface of a second region of the semiconductor layer 157. The second region of the semiconductor layer 157 is laterally spaced from the first region of the semiconductor layer 157. The exposed upper surface of the second region of the semiconductor layer 157 may have a width of about 2.6 $\mu$m. The exposed upper surface of the second region of the semiconductor layer 157 may also be referred to as an opening of the second mask 175. It will be appreciated that in other embodiments, the width of the exposed upper surface of the second region of the semiconductor layer may be more or less than 2.6 $\mu$m.

The method comprises is selectively doping the second region of the semiconductor layer 157 by implanting a p-type dopant. The p-type dopant may comprise boron, boron difluoride or another p-type dopant. The p-type dopant dosage is indicated in Figure 11 by reference numeral 160b.

The first and second regions of the semiconductor layer 157 may be implanted using an implantation process, such as vapour diffusion or another implantation process. An implantation energy used for implanting the p-type dopant may be between about 100 KeV and 850 KeV. An implantation energy used for implanting the n-type dopant in the above examples may be between about 140 KeV and 950 KeV. An implantation depth of the n-type and p-type dopants may be between about 0.5 $\mu$m and about 1.7 $\mu$m.

In step (d), the method comprises repeating steps (b) and (c). In this example, steps (b) and (c) are repeated six times. The number of repetitions of step (b) and (c) may be dependent on a required or desired breakdown voltage of the device 100. In the embodiments shown herein the required or desired breakdown voltage is about 600 V. However, it will be appreciated that in other embodiments, the required or desired breakdown voltage of the device may be more or less than 600 V. In such other embodiments, steps (b) and (c) may be repeated more or less than six times.

Each time step (b) is performed, a subsequent semiconductor layer 157 is deposited on a previously deposited semiconductor layer 157.

Each time step (b) is performed, the first mask 170 exposes a same first region of the subsequent semiconductor layer 157 as in one or more previous repetitions of step (b). Each time step (c) is performed, the second mask 175 exposes a same second region of the subsequent semiconductor layer 157 as in one or more previous repetitions of step (c). The order of the n-type doing or p-type doing may be changed.

The semiconductor layers 157 are doped using a p-type dopant dosage that decreases from about 1.16 x $10^{13}$ cm$^{-2}$ to about 1.09 x $10^{13}$ cm$^{-2}$ in the direction from the drift region 115 to the body region 120. The n-type dopant dosage 160a is the same for each semiconductor layer 157. The n- type dopant dosage may be about 1.1 x $10^{13}$ cm$^{-2}$. It will be appreciated that in other embodiments, the n-type dopant dosage may be varied across the semiconductor layers and the p-type dopant dosage may be constant. In such other embodiments, the n-type dopant dosage may be increased, e.g. from about 1.05 x $10^{13}$ cm$^{-2}$ to 1.11 x $10^{13}$ cm$^{-2}$, in the direction from the drift region to the body region. In such other embodiments, the p-type dopant dosage may be the same for each semiconductor layer. For example, the p-type dopant dosage may be about 1.1 x $10^{13}$ cm$^{-2}$.

In step (e), the method may comprise forming the first and second pillars 125a, 125b. For example, the method may comprise using a diffusion or redistribution process to form the first and second pillars 125a, 125b. The diffusion or redistribution process may comprise a drive-in process to further diffuse or redistribute the dopants, thereby forming the first and second pillars 125a, 125b. For example, the diffusion or redistribution process may be used to connect the first and second pillars 125a, 125b with each other.

A diffusion length of the n-type and p-type dopants during the initial vapour diffusion is generally less than a diffusion length of the n-type and p-type dopants during the drive-in process. Therefore, the drive-in process causes the n-type and p-type dopants to diffuse further into the semiconductor layers 157. During the drive-in process a temperature of the substrate 110, the drift region 115 and the semiconductor layers 157 is increased, e.g. to about 1125°C for about 10 hours. The drive-in process causes the n-type and p-type dopants on the surface of the semiconductor layers 157 to be diffused further into the semiconductor layers 157, thereby forming the first and second pillars 125a, 125b. This in turn results in the formation of the super junction region 125.

In step (e), the method comprises depositing a further semiconductor layer 180 on the super junction region 125, e.g. using a deposition process. The further semiconductor layer 180 may have a thickness of about 2 $\mu$m. However, it will be appreciated that in other embodiments, the further semiconductor layer may he have a thickness of more or less than 2 $\mu$m. The further semiconductor layer 180 may also be referred to as a cap layer.

In step (f), the method comprises forming a third mask on the further semiconductor layer 180. The third mask exposes a region of the further semiconductor layer 180 above the first pillar 125a. The third mask may be formed in the same manner as the first and second masks 170, 175 described above.

In step (f), the method comprises forming the JFET region 130. The JFET region 130 may be formed by doping the exposed region of the further semiconductor layer 180 with an n-type dopant, e.g. using the implantation process mentioned above. The n-type dopant may comprise one or more of the exemplary n-type dopants mentioned above.

In step (f), the method further comprises forming the gate oxide region 140a above the JFET region 130. The gate oxide region 140a may comprise a thin oxide layer, such as silicon dioxide, that can be deposited or thermally grown.

In step (f), the method further comprises forming the gate conductive region 135. The method comprises depositing a layer of conductive material on the gate oxide region 140a and over the JFET region 130, e.g. using a deposition process. The conductive material may comprise a doped semiconductor material, such as doped polysilicon. A material removal process, such as a dry-etch or wet-etch process, may be used to form the gate conductive region 135. For example, the layer of conductive material may be etched using a mask such that this layer extends over the JFET region 130 to the source contact regions 145.

In step (f), the method further comprises forming the body region 120. For example, a p-type dopant may be implanted on an upper surface of the further semiconductor layer 180 such that the p-type body region 120 is formed on either side of the JFET region 130. The p-type dopant may be implanted using a blank implantation process. Subsequent to the implantation of the p-type dopant, the diffusion or redistribution process, comprising the drive-in process, is performed to further diffuse or redistribute the p-type dopants in the body region 120. During the drive-in process a temperature of the substrate 110, the drift region 115, super junction region 125 and further semiconductor layer 180 is increased, e.g. to about 1125°C for about 100 minutes. The drive-in process causes the p-type dopant on the surface of the further semiconductor layer 180 to be diffused further into the further semiconductor layer 180, thereby forming the body region 120.

In step (f), the method further comprises forming the source contact regions 145. For example, an n-type dopant may be implanted on either side of the body region 120 to form the source contact regions 145. An n-type dopant concentration of each of the source contact regions 145 may be larger than $5 \times 10^{18}$ cm$^{-3}$. The n-type dopant may comprise one or more of the exemplary n-type dopants mentioned above. The n-type dopant may be implanted using a blank implantation process.

In step (f), the method further comprises forming the interlayer dielectric (ILD) layer 140b. For example, the interlayer dielectric layer 140b may be formed by depositing a layer of insulating material on or over the gate conductive region 135, e.g. using a deposition process. The layer of insulating material may comprise an oxide material, such as TEOS (tetraethyl orthosilicate). The interlayer dielectric layer 140b may also be deposited on or over the gate oxide region 140a.

In step (f), the method further comprises forming the p+ contact regions 150. The method comprises forming contact openings or recesses, e.g. using a material removal process, e.g. on either side of the gate conductive region 135. For example, the contact openings or recesses may be formed by etching through the interlayer dielectric layer 140b and the gate oxide region 140a. A p-type dopant may be implanted below each contact opening or recess to form the p$^+$ contact regions 150. A p-type dopant concentration of the p$^+$ contact region 150 may be larger than $5 \times 10^{18}$ cm$^{-3}$. The p-type dopant may comprise one or more of the exemplary p-type dopants mentioned above. The p-type dopant may be implanted using a blank implantation process.

In step (f), the method further comprises forming the source contact 155. For example, the source contact 155 may be formed by depositing a layer of conductive material into each contact opening or recess and on or over the interlayer dielectric layer 140b, e.g. such that the source contact 155 contacts the source contact regions 145 and the p+ contact regions 150.

In step (f), the method further comprises forming the drain contact 110a. For example, the drain contact 110a may be formed by grinding or planarising a lower surface of the substrate 110 and depositing a layer of conductive material thereon. The layer of conductive material may be deposited on the lower surface of the substrate 110 using a deposition process, such as an evaporation process.

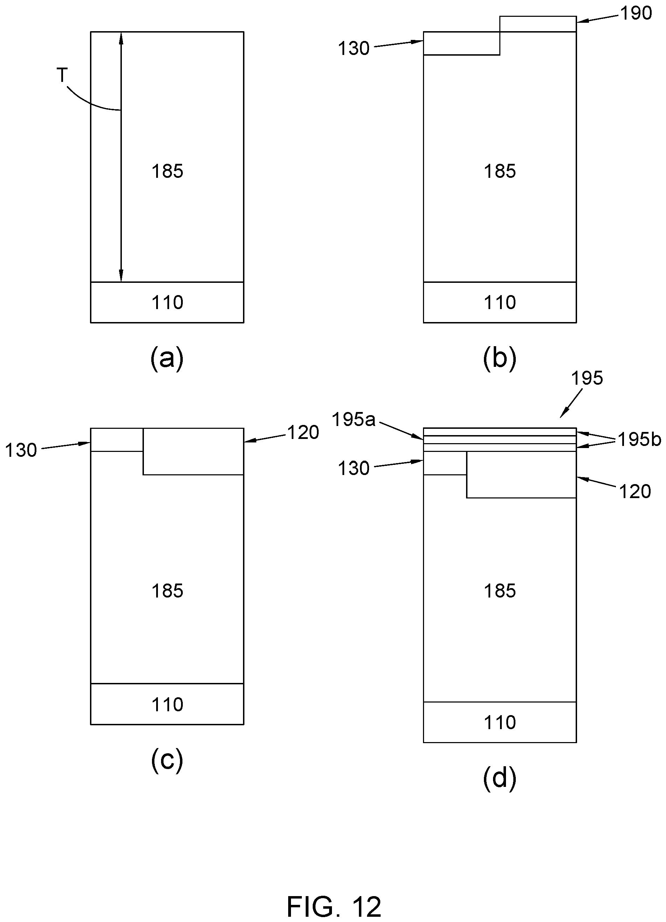

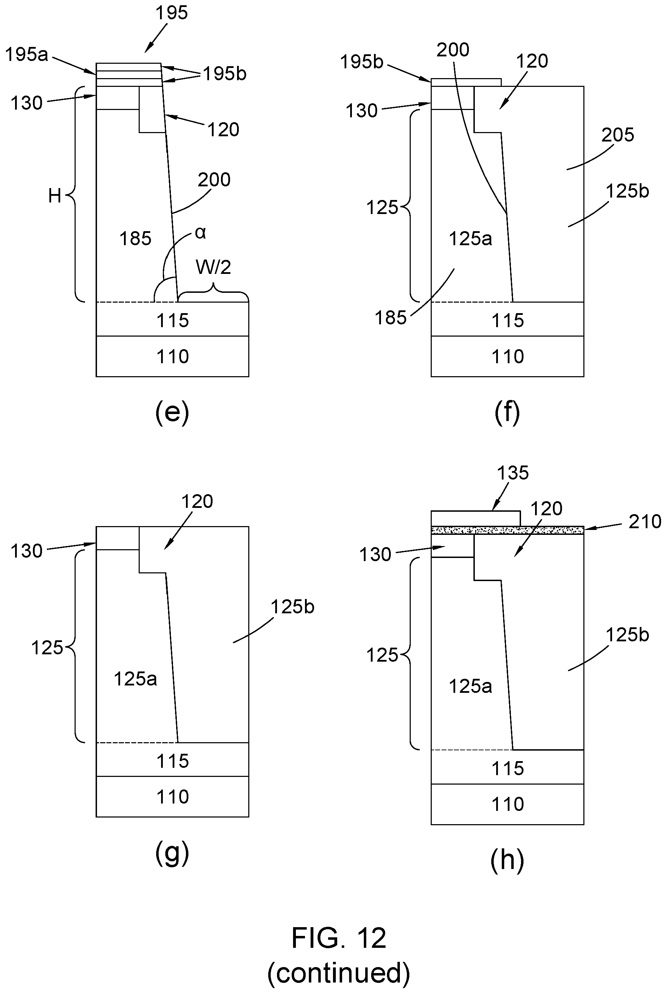

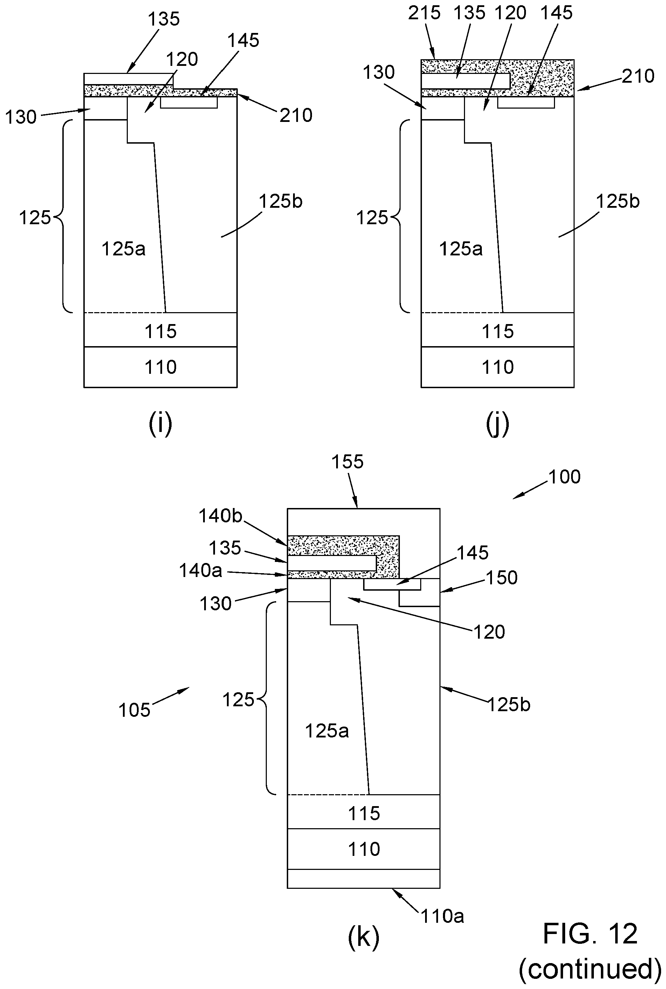

Figures 12(a) to 12(k) shows steps of another method of manufacturing an active region of a semiconductor power device according to an embodiment of the disclosure, such as the active region 105 of the device 100 described above. Many of the features are the same as those shown in Figures 1 and 2 and therefore carry the same reference numerals. It will be appreciated that the steps shown in Figures 12(a) to 12(k) may illustrate a subset of all the steps for manufacturing a device, and that the method may further include additional steps preceding or following the steps of Figures 12(a) to 12(k). Whilst Figures 12(a) to 12(k) show steps in manufacturing an active area having two first pillars 125a and one second pillar 125b, it will be understood that the method may be used to manufacture an active region comprising more than two first pillars and more than one second pillar. Figures 12(a) to 12(k) show the formation of a half of a unit cell of the device 100. However, it will be appreciated that any of the steps and/or features described below may also be applied to the formation of a unit cell of the device 100 or more than one unit cell of the device 100.

One or more of steps of the method described below in relation to Figures 12(a) to 12(k) are the same or similar to one or more steps of the method described above in relation to Figures 11(a) to 11(f). As such, one or more features of the method described above in relation to Figures 11(a) to 11(f) may also apply to the method described below in relation to Figures 12(a) to 12(k).

In step (a), the method comprises forming a semiconductor region 185. The semiconductor region 185 may be formed using a deposition process. In this embodiment, the semiconductor region 185 comprises an n-type doped semiconductor material, such as n-type doped silicon.

The semiconductor region 185 includes one or more epitaxial layers that have been formed on the substrate 110. A thickness T of the semiconductor region 185 may be about 50 $\mu$m. The thickness of the semiconductor region 185 may be dependent on the required or desired breakdown voltage of the device 100. In the embodiments shown herein the required or desired breakdown voltage is about 600 V. However, it will be appreciated that in other embodiments, the required or desired breakdown voltage of the device may be more or less than 600 V. In such other embodiments, the thickness of the semiconductor region may be more or less than 50 $\mu$m.

In step (b), the method comprises forming the JFET region 130. The step of forming the JFET region 130 may comprise forming a fourth mask 190 on the semiconductor region 185. The fourth mask exposes an upper surface of a first region of the semiconductor region 185. The fourth mask may be formed in the same manner as the first and second masks 170, 175 described above.

The JFET region 130 may be formed by doping the first region of the semiconductor region 185 with an n-type dopant, e.g. using the implantation process mentioned above. The n-type dopant may comprise one or more of the exemplary n-type dopants mentioned above.

In step (c), the method comprises forming the body region 120. The step of forming the body region 120 may comprise forming a fifth mask on the semiconductor region 185. The fifth mask exposes an upper surface of a second region of the semiconductor region 185. The second region of the semiconductor region 185 is located adjacent the JFET region 130. The fifth mask may be formed in the same manner as the first and second masks 170, 175 described above.

The body region 120 may be formed by doping the second region of the semiconductor region 185 with a p-type dopant. The p-type dopant may be implanted using a blank implantation process. Subsequent to the implantation of the p-type dopant, the diffusion or redistribution process, comprising the drive-in process, is performed to further diffuse or redistribute the p-type dopants in the body region 120. During the drive-in process a temperature of the substrate 110 and the semiconductor region 185 is increased, e.g. to about 1125°C for about 100 minutes. The drive-in process causes the p-type dopant on the surface of the semiconductor region 185 to be diffused further into the semiconductor region 185, thereby forming the body region 120.

In step (d), the method comprises depositing a layer of mask material 195 on the upper surface of the semiconductor region 185, e.g. over the JFET region 130 and the body region 120. The layer of mask material 195 comprises a stack of a layer of nitride material 195a sandwiched between two layers of oxide material 195b. The nitride material may comprise silicon nitride, such as such as $Si_3N_4$ or the like. The oxide material may comprise TEOS (tetraethyl orthosilicate) or the like. The layer of mask material 195 may be patterned, e.g. using a material removal process, such as a dry-etch process or a wet-etch process.

In step (e), the method comprises forming a trench 200 in the semiconductor region 185. The trench 200 is formed such that it extends through the body region 120 into semiconductor region 185. The trench 200 extends into the semiconductor region 185 in a vertical direction (e.g. a direction that is perpendicular to the substrate 110). The trench 200 is in contact with the body region 120. The trench 200 may be formed using a material removal process, such as a dry-etch process. The patterned layer of mask material may act as a hard mask or resists layer to define the trench 200 during the material removal process.

The trench 200 may comprise a height H of about 35 μm. The trench 200 may comprise a width of about 5 μm. As Figure 12(e) shows half of the unit cell of the device, the width of the trench 200 is indicated by reference numeral W/2. The sidewalls of the trench 200 may be formed at an angle α relative to a surface of the substrate 110. The angle α may be between about 80 degrees and about 90 degrees, such as about 88 degrees. A portion of the semiconductor region 185 below the trench 200 may define the drift region 115. The trench 200 is also in contact with the drift region 115. It will be appreciated that in other embodiments, a height and/or width of trench may be different from the exemplary height and/or width disclosed herein.

In step (f), e.g. subsequent to the formation of the trench 200, a portion of the layer of mask material 195 may be removed, e.g. using a material removal process, such as a wet-etch process. In this embodiment, the upper of the two layers of oxide material 195b and the layer of nitride material 195a are removed. The lower of two layers of oxide material 195b remains on the upper surface of the semiconductor region 185, e.g. on the body region 120 and the JFET region 130.

In step (f), the method further comprises filling the trench 200 with a p-type semiconductor material 205, such as p-type doped silicon. The trench 200 may be filled with the semiconductor material 205 using a deposition process. In this embodiment, the semiconductor material 205 may be doped such that a doping concentration of the semiconductor material 205 in the trench 200 decreases in a direction along the trench 200 from the drift region 115 to the body region 120. For example, the p-type doping concentration of the semiconductor material 205 in the trench 200 may decrease from about $7.35 \times 10^{15}$ cm$^{-3}$ to $6.9 \times 10^{15}$ cm$^{-3}$ in the direction along the trench 200 from the drift region 115 to the body region 120. The direction along the trench 200 may also be understood as a vertical direction, e.g. a direction parallel to a longitudinal axis of the trench 200. In this embodiment, the trench 200 forms the second pillar 125b. A portion of the semiconductor region 185 that is located adjacent to the trench 200 forms the first pillar 125a. A doping concentration of the first pillar 125a is constant in the direction along the first pillar from the drift region 115 to the body region 120. For example, an n-type doping concentration of the first pillar 125a may be about $7 \times 10^{15}$ cm$^{-3}$. However, it will be appreciated that in other embodiments, a doping concentration of the first pillar may increases in the direction along the first pillar from the drift region to the body region and a doping concentration of the second pillar or portion thereof may be constant in the direction along the second pillar from the drift region to the body region. In such other embodiments, the p-type doping concentration of the second pillar or portion thereof may be about $7 \times 10^{15}$ cm$^{-3}$. The n-type doping concentration of the first pillar may increase from about $6.65 \times 10^{15}$ cm$^{-3}$ to about $7.2 \times 10^{15}$ cm$^{-3}$ in the direction along the first pillar from the drift region 115 to the body region 120.

In this embodiment, the body region 120 is located on a part of the super junction region 125, e.g. on at least a part of the first pillar 125a. As such, the super junction region 125 can be considered as being arranged at least partially between the drift region 115 and the body region 120.

In step (f), the method further comprises removing a portion of the semiconductor material 205 that extends beyond the body region 120 and the JFET region 130, e.g. using a material removal process, such as a dry-etch process or chemical-mechanical polishing process.

In step (g), the method comprises removing a remainder of the layer of mask material 195, e.g. the lower of two layers of oxide material 195b. The remainder of the layer of mask material 195 may be removed using a material removal process, such as a wet-etch process. A sacrificial layer of oxide material may be deposited on the JFET region 130, the body region 120 and the second pillar 125b. The sacrificial layer of oxide material may subsequently be removed.

In step (h), the method comprises depositing a layer of oxide material 210, such as silicon dioxide, on the JFET region 130, the body region 120 and the second pillar 125b.

In step (h), the method further comprises forming the gate conductive region 135. The method comprises depositing a layer of conductive material on the layer of oxide material 210. The conductive material may comprise a doped semiconductor material, such as doped polysilicon. A material removal process, such as a dry-etch or wet-etch process, may be used to form the gate conductive region 135. For example, the layer of conductive material may be etched using a mask such that this layer extends over the JFET region 130 and the body region 120. A portion of the layer of oxide material 210 that is located over the second pillar 125b is exposed.

In step (i), the method comprises partially removing the exposed portion of the layer of oxide material 210 using a material removal process, such as a dry-etch or wet-etch process.

In step (i), the method further comprises forming the source contact region 145. For example, an n-type dopant is implanted in a region of the second pillar 125b adjacent to the body region 120 to form the source contact regions 145. The region of the second pillar 125b that is implanted with the n-type dopant is located below the layer of oxide material 210 and extends from the exposed portion of the layer of oxide material 210 to the gate conductive region 135. A sixth mask exposes the region of the second pillar 125b to be implanted.

An n-type dopant concentration of the source contact region 145 may be larger than $5 \times 10^{18}$ cm$^{-3}$. The n-type dopant may comprise one or more of the exemplary n-type dopants mentioned above. The n-type dopant may be implanted using a blank implantation process. Subsequent to the implantation of the n-type dopant, the diffusion or redistribution process, comprising the drive-in process, is performed to further diffuse or redistribute the n-type dopants in the region of the second pillar 125b. During the drive-in process a temperature of at least the second pillar 125b is increased, e.g. to about 1000°C for about 30 minutes. The drive-in process causes the n-type dopant on the surface of the region of the second pillar 125b to be diffused further into this region, thereby forming the source contact region 145.

In step (j), the method comprises forming the interlayer dielectric layer 140b. For example, the interlayer dielectric layer 140b may be formed by depositing a layer of insulating material on or over the gate conductive region 135 and the exposed portion of the layer of oxide material 210, e.g. using a deposition process. The layer of insulating material may comprise an oxide material, such as TEOS (tetraethyl orthosilicate).

In step (k), the method further comprises forming the p+ contact region 150. The method comprises forming an opening or recess, e.g. using a material removal process. The opening or recess is laterally spaced from the gate conductive region 135. The contact opening or recess may be formed by etching through the interlayer dielectric layer 140b and the layer of oxide material 210. The remainder of the layer of oxide material 210 forms the gate oxide region 140a.

A p-type dopant may be implanted below the contact opening or recess to form the p$^+$ contact region 150. A p-type dopant concentration of the p$^+$ contact region 150 may be larger than $5 \times 10^{18}$ cm$^{-3}$. The p-type dopant may comprise one or more of the exemplary p-type dopants mentioned above. The p-type dopant may be implanted using a blank implantation process.

In step (k), the method further comprises forming the source contact 155. For example, the source contact 155 may be formed by depositing a layer of conductive material into the contact opening or recess and on or over the interlayer dielectric layer 140b, e.g. such that the source contact 155 contacts the source contact region 145 and the p+ contact region 150.

In step (k), the method further comprises forming the drain contact 110a. For example, the drain contact 110a may be formed by grinding or planarising a lower surface of the substrate 110 and depositing a layer of conductive material thereon. The layer of conductive material may be deposited on the lower surface of the substrate 110 using a deposition process, such as an evaporation process.

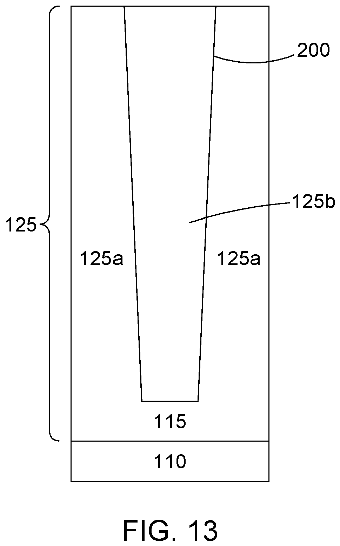

Figure 13 shows schematically a cross-section of a super junction region 125 that has been formed using one or more steps of the method described in relation to Figures 12(a) to 12(k). In the embodiment shown in Figure 13, the super junction region 125 comprises a second pillar 125b that is arranged between two portions of two first pillars 125a. However, it will be appreciated that the device 100 may more than one second pillar 125b and more than two first pillars 125a, as mentioned above.

The deposition process described above may comprise a chemical vapour deposition process, sputtering process or another deposition process.

The dry-etch process mentioned above may include a reactive ion etch process or another dry-etch process.

It will be appreciated that the term "constant" used herein encompasses the terms "substantially constant."

It will be appreciated that the terms "the same" used herein encompasses the terms "substantially the same."

It will be appreciated that the term "width" used herein encompasses a size, dimension or extension of a part or feature in a lateral direction, e.g. a direction parallel to the y-axis in Figure 4.

It will be appreciated that the term "thickness" or "height" used herein encompasses a size, dimension or extension of a part or feature in a longitudinal or vertical direction, e.g. a direction parallel to the x-axis in Figure 4 and/or a direction perpendicular to the lateral direction.

The skilled person will understand that in the preceding description and appended claims, positional terms such as 'above', 'overlap', 'under', 'lateral, etc. are made with reference to conceptual illustrations of an apparatus, such as those showing standard cross-sectional perspectives and those shown in the appended drawings. These terms are used for ease of reference but are not intended to be of limiting nature. These terms are therefore to be understood as referring to a device when in an orientation as shown in the accompanying drawings.

It will be appreciated that all doping polarities mentioned above could be reversed, the resulting devices still being in accordance with embodiments of the present invention.

Although the above description refers to the device comprising a MOSFET, it will be appreciated that in other embodiments the device may comprise an insulated-gate bipolar transistor (IGBT). Any of the above-mentioned features may also apply to the IGBT. In such other embodiments, the terms "drain region" may be replaced with the terms "collector region" and the term "source", as used above, may be replaced with the term "emitter".

In this document, dimensions are provided merely as indicative examples, and are not intended to be limiting.

It will be appreciated that Figures 1 to 3(f), 11(a) to 11(f), 12(a) to 12(k) and 13 are schematic drawings of some embodiments of the disclosure and may not be to scale.

Although specific embodiments have been described above, the claims are not limited to those embodiments. Those skilled in the art will be able to make modifications and alternatives in view of the disclosure, which are contemplated as falling within the scope of the appended claims. Each feature disclosed may be incorporated in any of the described embodiments, alone or in an appropriate combination with other features disclosed herein.

Reference Numerals

100 Device
105 Active region
110 Substrate
110a Drain contact
115 Drift region
120 Body region
125 Super junction region
125a First pillar
125b Second pillar
130 JFET region
135 Gate conductive region
140a Gate oxide region
140b Interlayer dielectric layer
145 n$^+$ source contact region
150 p$^+$ contact region 150
155 Source contact
155 Source contact
157 Semiconductor layer
160a n-type dopant dosage
160b p-type dopant dosage
160c Enrichment region
165 Impact ionisation location
170 First mask
175 second mask
180 Further semiconductor layer
185 Semiconductor region
190 Fourth mask
195 Layer of mask material
195a Layer of nitride material
195b Layer of oxide material
200 Trench
205 p-type semiconductor material
210 Layer of oxide material
H Height of trench
W Width of trench
$\alpha$ Angle of sidewall of trench
T thickness of semiconductor region

**Claims**

1. A semiconductor power device comprising an active region, the active region comprising:

   a drift region of a first conductivity type;
   a body region of a second conductivity type, wherein the second conductivity type is opposite to the first conductivity type;
   a super junction region arranged at least partially between the drift region and the body region, the super junction region comprising:

      a first pillar of the first conductivity type,
      at least a portion of a second pillar of the second conductivity type, the first pillar being arranged adjacent to the portion of the second pillar, wherein at least one of:

a doping concentration of the first pillar is constant in a direction along the first pillar from the drift region to the body region and a doping concentration of the portion of the second pillar decreases in a direction along the portion of the second pillar from the drift region to the body region; or
the doping concentration of the first pillar increases in the direction along the first pillar from the drift region to the body region and the doping concentration of the portion of the second pillar is constant in the direction along the portion of the second pillar from the drift region to the body region.

2. A semiconductor power device according to claim 1, wherein at least one of:

the doping concentration of the portion of the second pillar decreases linearly in the direction along the portion of the second pillar from the drift region to the body region; or
the doping concentration of the first pillar increases linearly in the direction along the first pillar from the drift region to the body region.

3. A semiconductor power device according to claim 1, wherein at least one of:

the doping concentration of the portion of the second pillar decreases stepwise in the direction along the portion of the second pillar from the drift region to the body region; or
the doping concentration of the first pillar increases stepwise in the direction along the first pillar from the drift region to the body region.

4. A semiconductor power device according to claim 3, wherein at least one of:

the doping concentration of the portion of the second pillar decreases in two or more steps; or
the doping concentration of the first pillar increases in two or more steps.

5. A semiconductor power device according to any preceding claim, wherein the doping concentration of the first pillar at or near the body region is larger, smaller or the same as the doping concentration of the portion of the second pillar at or near the body region.

6. A semiconductor power device according to any preceding claim, wherein the super junction region comprises a plurality of first pillars and a plurality of second pillars alternately arranged with each other.

7. A semiconductor power device according to claim 6, wherein each of the plurality of first pillars is arranged adjacent at least one of the plurality of second pillars.

8. The semiconductor power device according to any preceding claim, wherein the semiconductor power device comprises a metal-oxide-semiconductor field-effect transistor (MOSFET) or an insulated-gate bipolar transistor (IGBT).

9. A method of manufacturing an active region of a semiconductor power device, the method comprising:

forming a drift region of a first conductivity type on a substrate;
forming a super junction region on the drift region, the super junction region comprising:

a first pillar of the first conductivity type,
at least a portion of a second pillar of the second conductivity type, the first pillar being arranged adjacent to the portion of the second pillar, wherein at least one of:

a doping concentration of the first pillar is constant in a direction along the first pillar from the drift region to the body region and a doping concentration of the portion of the second pillar decreases in a direction along the portion of the second pillar from the drift region to the body region; or
the doping concentration of the first pillar increases in the direction along the first pillar from the drift region to the body region and the doping concentration of the portion of the second pillar is constant in the direction along the portion of the second pillar from the drift region to the body region;

forming a body region of a second conductivity type on at least a part of the super junction region.

10. A method according to claim 9, wherein forming the super junction region comprises:
performing each of steps (i) to (v) one or more times:

(i) depositing a semiconductor layer on or over the drift region;
(ii) forming a first mask on the semiconductor layer, the first mask exposing an upper surface of a first region of the semiconductor layer;

(iii) selectively doping the first region of the semiconductor layer to form a first region of a first conductivity type;

(iv) forming a second mask on the semiconductor layer, the second mask exposing an upper surface of a second region of the semiconductor layer, the second region of the semiconductor layer being laterally spaced from the first region of the semiconductor layer; and

(v) selectively doping the second region of the semiconductor layer to form a second region of a second conductivity type.

11. A method according to claim 10, wherein in a first iteration, the semiconductor layer is deposited on the drift region and wherein in one or more subsequent iterations, a subsequent semiconductor layer is deposited on a previously deposited semiconductor layer.

12. A method according to claim 11, wherein when at least one subsequent iteration has been performed:

a doping concentration of each first region of the first conductivity type is the same; and
a doping concentration of a second region of the second conductivity type formed in the at least one subsequent iteration is decreased relative to a doping concentration of a second region of the second conductivity type formed in a previous iteration.

13. A method according to claim 11, wherein when at least one subsequent iteration has been performed:

a doping concentration of each second region of the second conductivity type is the same; and
a doping concentration of a first region of the first conductivity type formed in the at least one subsequent iteration is increased relative to a doping concentration of a first region of the first conductivity type formed in a previous iteration.

14. A method according to any one of claims 9 to 13 comprising using a diffusion or redistribution process to form the first pillar and at least the portion of the second pillar.

15. A method according to claim 9, wherein forming the super junction region comprises:

forming a trench in a semiconductor region of a first conductivity type, wherein a portion of the semiconductor region that is located adjacent to the trench forms the first pillar; and
filling the trench with a semiconductor material of a second conductivity type to form at least the portion of the second pillar.

16. A method of manufacturing a semiconductor power device comprising:
manufacturing an active region of the semiconductor power device according to any one of claims 9 to 15.

FIG. 1

FIG. 2

FIG. 3

FIG. 4

FIG. 5

FIG. 6

| | | FIG.3(a) | FIG.3(b) | FIG.3(c) | FIG.3(d) | FIG.3(e) | FIG.3(f) |
|---|---|---|---|---|---|---|---|
| ▨ | $V_B$ (V) | 543.7 | 614 | 675 | 509 | 544 | 694 |
| ▧ | Rsp (mΩ•cm2) | 9.6 | 9.9 | 10.1 | 9.4 | 9.5 | 9.9 |
| ▤ | FOM | 56.6 | 62 | 66.8 | 54.1 | 57.3 | 70.1 |

FIG. 7

FIG. 8

(d) 165

(e) 165

(f) 165

FIG. 8
(continued)

FIG. 9

FIG. 10

(a)

(b)

(c)

(d)

FIG. 11

(e)

(f)

FIG. 11
(continued)

FIG. 12

(e)

(f)

(g)

(h)

FIG. 12
(continued)

(i)

(j)

(k)

FIG. 12
(continued)

**FIG. 13**

Europäisches
Patentamt

European
Patent Office

Office européen
des brevets

# EUROPEAN SEARCH REPORT

Application Number

EP 24 20 9922

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2016/064478 A1 (SUN HE [CN] ET AL) 3 March 2016 (2016-03-03) | 1,3-9, 15,16 | INV. H10D30/66 |
| Y | * Figure 3, 4 and 5 and correlated text passages. * | 10-12 | H10D12/00 H10D62/00 |
| | - - - - - | | H10D62/10 |
| X | DE 102 45 049 A1 (INFINEON TECHNOLOGIES AG [DE]) 8 April 2004 (2004-04-08) | 1,3-11, 13,14,16 | |
| Y | * Figure 3 and correlated text passages. * | 2,10-12 | |
| | - - - - - | | |
| Y | US 2008/246079 A1 (SAITO WATARU [JP] ET AL) 9 October 2008 (2008-10-09) * Figure 8 and correlated text passages. * | 2 | |
| | - - - - - | | |

TECHNICAL FIELDS
SEARCHED       (IPC)

H10D

The present search report has been drawn up for all claims

| Place of search | Date of completion of the search | Examiner |
|---|---|---|
| Munich | 12 March 2025 | Tretnak, Veronika |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

..........................................................................

& : member of the same patent family, corresponding
    document

EPO FORM 1503 03.82 (P04C01)

2

## ANNEX TO THE EUROPEAN SEARCH REPORT
## ON EUROPEAN PATENT APPLICATION NO.

EP 24 20 9922

This annex lists the patent family members relating to the patent documents cited in the above-mentioned European search report.
The members are as contained in the European Patent Office EDP file on
The European Patent Office is in no way liable for these particulars which are merely given for the purpose of information.

12-03-2025

| Patent document cited in search report | Publication date | Patent family member(s) | | Publication date |
|---|---|---|---|---|
| US 2016064478 A1 | 03-03-2016 | CN | 104241376 A | 24-12-2014 |
| | | US | 2016064478 A1 | 03-03-2016 |
| | | US | 2018158900 A1 | 07-06-2018 |
| DE 10245049 A1 | 08-04-2004 | NONE | | |
| US 2008246079 A1 | 09-10-2008 | JP | 4564509 B2 | 20-10-2010 |
| | | JP | 2008258442 A | 23-10-2008 |
| | | US | 2008246079 A1 | 09-10-2008 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 9595596 B2
- US 9024381 B2
- US 6630698 B1
- US 8283720 B2